(19) Europäisches Patentamt
European Patent Office
Office européen des brevets

(11) **EP 2 140 278 B1**

(12) **EUROPÄISCHE PATENTSCHRIFT**

(45) Veröffentlichungstag und Bekanntmachung des Hinweises auf die Patenterteilung:
**24.11.2010 Patentblatt 2010/47**

(21) Anmeldenummer: **07722341.0**

(22) Anmeldetag: **26.04.2007**

(51) Int Cl.:
*G01R 27/28* (2006.01)    *B60L 15/00* (2006.01)

(86) Internationale Anmeldenummer:
**PCT/DE2007/000784**

(87) Internationale Veröffentlichungsnummer:
**WO 2008/131707 (06.11.2008 Gazette 2008/45)**

(54) **VERFAHREN ZUM ERMITTELN ELEKTRISCHER PARAMETER EINES STRECKENABSCHNITTS EINER MAGNETSCHWEBEBAHN**

METHOD FOR DETERMINING ELECTRIC PARAMETERS OF A ROUTE SECTION OF A MAGNETIC SUSPENSION RAILWAY

PROCÉDÉ DE DÉTERMINATION DES PARAMÈTRES ÉLECTRIQUES D'UNE SECTION DE VOIE POUR UN TRAIN À SUSTENTATION MAGNÉTIQUE

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**06.01.2010 Patentblatt 2010/01**

(73) Patentinhaber: **Siemens Aktiengesellschaft 80333 München (DE)**

(72) Erfinder: **DERFIORA, Rizqa 91052 Erlangen (DE)**

(74) Vertreter: **Wolff, Harry Siemens Aktiengesellschaft Postfach 22 16 34 80506 München (DE)**

(56) Entgegenhaltungen:
EP-A- 1 172 660    DE-A- 10 253 865
GB-A- 1 057 896

## Beschreibung

Die Erfindung bezieht sich auf ein Verfahren mit den Merkmalen gemäß dem Oberbegriff des Anspruchs 1.

Zur Steuerung einer Magnetschwebebahn, insbesondere zur Regelung des Schubkraftstroms einer Magnetschwebebahn, ist es erforderlich, die elektrischen Parameter der einzelnen Streckenabschnitte der Magnetschwebebahn möglichst genau zu kennen.

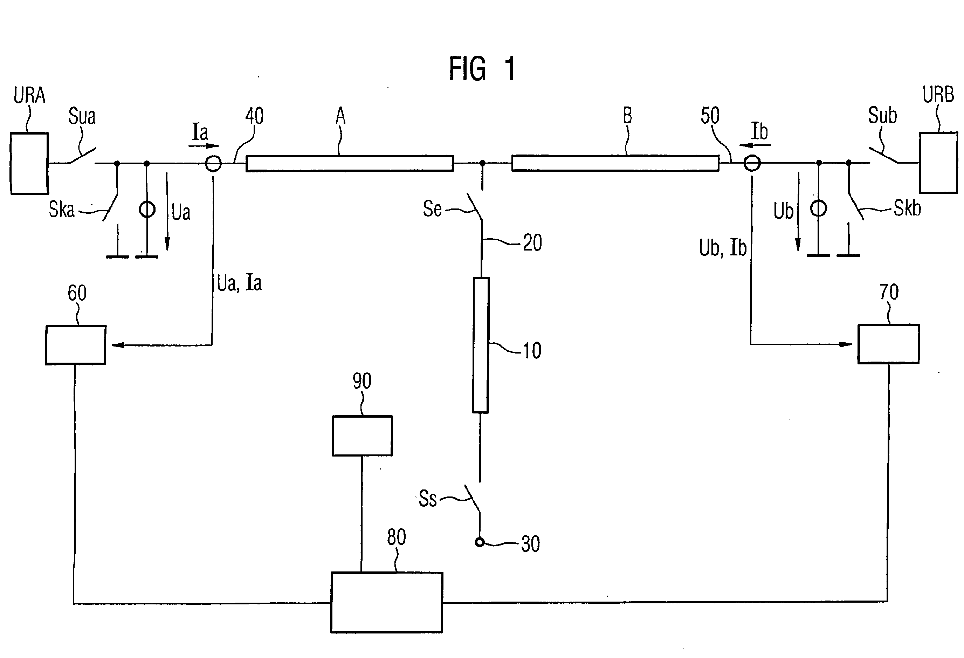

Von der in Shanghai gebauten Transrapidstrecke ist es bekannt, für jeden Streckenabschnitt einen entsprechenden Parametersatz zu bestimmen. Ein Streckenabschnitt besteht dabei zumindest aus einem einen Antriebsabschnitt der Magnetschwebebahn bildenden Statorabschnitt und einem Streckenkabel, das den Statorabschnitt mit einer zugeordneten Umrichtereinrichtung verbindet. Zur Bestimmung des Parametersatzes werden die Strom- und Spannungswerte an der elektrischen Verbindungsstelle zwischen dem Streckenkabel und der Umrichtereinrichtung gemessen. Mit diesen Messwerten werden anschließend die Parameter des Parametersatzes ermittelt und damit der Parametersatz gebildet. Die vorbekannte Vorgehensweise zur Bestimmung der Parameter ist anhand der Figur 1 vereinfacht dargestellt:

Man erkennt in der Figur 1 einen Statorabschnitt 10, dessen einer Anschluss 20 über einen Schalter Se mit einem Streckenkabel A und einem weiteren Streckenkabel B verbunden ist. Das Statorabschnittsanschluss 30 des Statorabschnitts 10 ist über einen Schalter Ss mit dem Sternpunkt verbunden.

Das Streckenkabel A steht mit seinem Einspeiseanschluss 40 über Schalter Sua und Ska mit einer Umrichtereinrichtung URA in Verbindung. Das weitere Streckenkabel B steht mit seinem Einspeiseanschluss 50 über Schalter Sub und Skb mit einer weiteren Umrichtereinrichtung URB in Verbindung.

Zur Bestimmung der Parameter des Streckenabschnitts werden mit einer umrichterbezogenen Messeinrichtung 60 und einer weiteren umrichterbezogenen Messeinrichtung 70, die beispielsweise über eine Stromregelung 80 der Magnetschwebebahn mit einer Auswerteinrichtung 90 verbunden sein können, Messungen am Einspeiseanschluss 40 sowie am Einspeiseanschluss 50 vorgenommen. Bei der Messung am Einspeiseanschluss 40 werden die Schalter Se und Sub geöffnet und die Spannungen Ua und die Ströme Ia für ein offenes Streckenkabelende (Skb offen) und ein geschlossenes Streckenkabelende (Skb geschlossen) gemessen. Bei der Messung am Einspeiseanschluss 50 werden die Schalter Se und Sua geöffnet und die Spannungen Ub und die Ströme Ib für ein offenes Streckenkabelende (Ska offen) und ein geschlossenes Streckenkabelende (Ska geschlossen) gemessen. Mit den entsprechenden Messwerten werden die elektrischen Parameter der beiden Streckenkabel A und B ermittelt. Die Eigenschaften des Statorabschnitts 10 werden nachfolgend aus Strommesswerten der Ströme Ia und Ib und Spannungsmesswerten der Spannungen Ua und Ub rückgerechnet, die bei geschlossenem Schalter Se bestimmt werden. Ein solches Rückrechnen ist möglich, da die Eigenschaften der beiden Streckenkabel A und B separat vom Statorabschnitt 10 zu diesem Zeitpunkt bereits bekannt sind.

Nachteilig bei dem vorbekannten Verfahren ist, dass die Messungen mit äußerster Vorsicht durchgeführt werden müssen, um Beschädigungen an den Umrichtereinrichtungen URA und URB zu vermeiden. Bei der Kurzschlussmessung, wenn also die Schalter Ska oder Skb geschlossen sind, können Kurzschlussströme mit sehr großen Oberschwingungsanteilen fließen, wodurch unter Umstände in den Umrichtereinrichtungen enthaltene Halbleiterventile zerstört werden können.

DE 102 53 865 A1 (Siemens) offenbart ein Verfahren zum Ermitteln elektrischer Parameter.

Ausgehend von einem Verfahren der eingangs angegebenen Art liegt der Erfindung somit die Aufgabe zugrunde, ein Verfahren zur Parameterbestimmung anzugeben, bei dem die Gefahr einer Beschädigung der Umrichtereinrichtungen vermieden, zumindest deutlich reduziert ist.

Diese Aufgabe wird erfindungsgemäß durch ein Verfahren mit den Merkmalen gemäß Anspruch 1 gelöst. Vorteilhafte Ausgestaltungen des erfindungsgemäßen Verfahrens sind in Unteransprüchen angegeben.

Danach ist erfindungsgemäß vorgesehen, dass die Strom- und Spannungswerte an der elektrischen Verbindungsstelle zwischen dem Streckenkabel und der Umrichtereinrichtung gemessen werden, wenn der Statorabschnitt mit dem Streckenkabel elektrisch verbunden ist, zusätzlich die Strom- und Spannungswerte an der elektrischen Verbindungsstelle zwischen dem Streckenkabel und dem Statorabschnitt sowie die Stromwerte an der Sternpunktseite des Statorabschnitts gemessen werden und diese zusätzlichen Messwerte beim Ermitteln der Parameter ebenfalls berücksichtigt werden.

Ein wesentlicher Vorteil des erfindungsgemäßen Verfahrens ist darin zu sehen, dass die Gefahr von Beschädigungen der Umrichtereinrichtungen relativ gering ist; aufgrund des während der Messungen parallel geschalteten Statorabschnitts sind die Stromoberschwingungsanteile frequenzmäßig verschoben und die Eigenfrequenzen des elektrischen Gesamtsystems gegenüber einer Messung mit abgeschaltetem Statorabschnitt deutlich günstiger verteilt. Die Kurzschlussmessungen mit geschlossenen Schaltern Ska bzw. Skb entsprechen somit elektrischen Zuständen, wie sie während des üblichen Betriebs der Magnetschwebebahn auftreten können, so dass die Gefahr einer Zerstörung der Umrichtereinrichtungen während der Parameterbestimmung relativ gering ist.

Besonders einfach und damit vorteilhaft lassen sich die Parameter bestimmen, wenn die Messwerte mit Hilfe der Vierpoltherie ausgewertet werden.

Wie bereits eingangs erwähnt, kann der Statorabschnitt über ein weiteres Streckenkabel mit einer weiteren Umrichtereinrichtung verbunden sein: In diesem Falle wird es als vorteilhaft angesehen, wenn die Strom- und Spannungswerte an der elektrischen Verbindungsstelle zwischen dem weiteren Streckenkabel und der weiteren Umrichtereinrichtung bei eingeschaltetem Statorabschnitt ebenfalls gemessen werden und diese Messwerte beim Ermitteln der Parameter zusätzlich berücksichtigt werden.

Für den Parametersatz werden vorzugsweise einer oder mehrere der folgenden Parameter bestimmt: der elektrische Widerstand, die Induktivität, die Kapazität, der elektrische Widerstandsbelag, der Induktivitätsbelag, der Ableitungsbelag, der Kapazitätsbelag und/oder der Leitwert, sei es für das Streckenkabel, das weitere Streckenkabel und/oder den Statorabschnitt.

Vorzugsweise werden die Strom- und Spannungswerte an der elektrischen Verbindungsstelle zwischen dem Streckenkabel und der Umrichtereinrichtung und die Strom- und Spannungswerte an der elektrischen Verbindungsstelle zwischen dem Streckenkabel und dem Statorabschnitt jeweils dreiphasig gemessen und phasenleiterindividuell ausgewertet.

Die Strom- und Spannungswerte an der elektrischen Verbindungsstelle zwischen dem Streckenkabel und dem Statorabschnitt sowie die Stromwerte an der Sternpunktseite des Statorabschnitts können mit einer mobilen Messeinrichtung erfasst und zu einer stationären Auswerteinrichtung übertragen werden, mit der dann die Parameter ermittelt werden.

Alternativ können die Strom- und Spannungswerte an der elektrischen Verbindungsstelle zwischen dem Streckenkabel und dem Statorabschnitt sowie die Stromwerte an der Sternpunktseite des Statorabschnitts mit einer stationären Messeinrichtung erfasst und zu einer stationären Auswerteinrichtung übertragen werden, mit der dann die Parameter ermittelt werden.

Nach dem Bestimmen der Parameter werden die Strom- und Spannungswerte an der elektrischen Verbindungsstelle zwischen dem Streckenkabel und der Umrichtereinrichtung, die Strom- und Spannungswerte an der elektrischen Verbindungsstelle zwischen dem Streckenkabel und dem Statorabschnitt sowie die Stromwerte an der Sternpunktseite des Statorabschnitts während des Betriebs der Magnetschwebebahn zumindest ein weiteres Mal, vorzugsweise wiederholt, gemessen, um die sich aus den Messwerten jeweils ergebenden Parameter zu ermitteln und die jeweils aktuellen Parameter zur Aktualisierung des Parametersatzes zu verwenden.

Als besonders vorteilhaft wird es angesehen, wenn die Strom-und Spannungswerte an der elektrischen Verbindungsstelle zwischen dem Streckenkabel und dem Statorabschnitt auch dazu verwendet werden, während des Betriebs der Magnetschwebebahn die Position eines Fahrzeugs auf dem Statorabschnitt zu bestimmen. Zur Bestimmung der Position des Fahrzeugs werden vorzugsweise zusätzlich auch die Stromwerte an der Sternpunktseite des Statorabschnitts herangezogen.

Auch wird es als vorteilhaft angesehen, wenn der gemessene Sternpunktstrom näherungsweise als Statorstrom unterhalb eines auf dem Statorabschnitt befindlichen Fahrzeugs angesehen wird und unter dieser Annahme der Schubkraftstrom der Magnetschwebebahn eingestellt wird.

Die Erfindung bezieht sich außerdem auf eine Anordnung zum Ermitteln eines Parametersatzes, der elektrische Parameter eines Streckenabschnitts einer Magnetschwebebahn beschreibt, wobei der Streckenabschnitt einen einen Antriebsabschnitt der Magnetschwebebahn bildenden Statorabschnitt und ein Streckenkabel, das den Statorabschnitt mit einer zugeordneten Umrichtereinrichtung verbindet, umfasst, wobei die Anordnung eine umrichterbezogene Messeinrichtung aufweist, die an die elektrischen Verbindungsstelle zwischen dem Streckenkabel und der Unrichtereinrichtung angeschlossen ist und während ihres Betriebs die Strom- und Spannungswerte an der Verbindungsstelle misst, und wobei die Anordnung eine Auswerteinrichtung aufweist, die mit der umrichterbezogenen Messeinrichtung in Verbindung steht und mit den Messwerten der umrichterbezogenun Meßeinrichtung die Parameter des Parametersatzes ermittelt und damit den Parametersatz bildet.

Erfindungsgemäß ist bezüglich einer solchen Anordnung vorgesehen, dass die Anordnung zusätzlich eine statorbezogene Messeinrichtung aufweist, die eingangsseitig an die elektrische Verbindungsstelle zwischen dem Streckenkabel und dem Statorabschnitt sowie an die Sternpunktseite des Statorabschnitts angeschlossen ist und ausgangsseitig mit der Auswerteinrichtung in Verbindung steht, wobei die statorbezogene Messeinrichtung derart ausgestaltet ist, dass sie während ihres Betriebs die Strom- und Spannungswerte an der Verbindungsstelle zwischen dem Streckenkabel und dem Statorabschnitt sowie die Stromwerte an der Sternpunktseite misst und diese zur Auswerteinrichtung übermittelt, wobei die Auswerteinrichtung derart ausgestaltet ist, dass sie die Messwerte der statorbezogenen Messeinrichtung bei der Ermittlung der Parameter zusätzlich berücksichtigt und die Messungen durchführt, wenn der Statorabschnitt mit dem Streckenkabel elektrisch verbunden ist.

Vorzugsweise weist die Anordnung eine weitere umrichterbezogene Messeinrichtung auf, die eingangsseitig an die elektrische Verbindungsstelle zwischen einem weiteren Streckenkabel und einer weiteren Umrichtereinrichtung und ausgangsseitig an die Auswerteinrichtung angeschlossen ist und die derart ausgestaltet ist, dass sie während ihres Betriebs die Strom- und Spannungswerte an der Verbindungsstelle zwischen dem weiteren Streckenkabel und der weiteren Umrichtereinrichtung misst und diese zur Auswerteinrichtung übermittelt.

Die statorbezogene Messeinrichtung kann durch eine mobile Einheit oder durch eine stationäre Einheit gebildet sein. Die Auswerteinrichtung kann Bestandteil einer solchen mobilen oder stationären Einheit sein oder eine separate Komponente bilden.

Bevorzugt ist die Anordnung derart ausgestaltet, dass sie nach dem Bestimmen der Parameter die Strom- und Spannungswerte an der elektrischen Verbindungsstelle zwischen dem Streckenkabel und der Umrichtereinrichtung, die Strom- und Spannungswerte an der elektrischen Verbindungsstelle zwischen dem Streckenkabel und dem Statorabschnitt sowie die Stromwerte an der Sternpunktseite des Statorabschnitts während des Betriebs der Magnetschwebebahn zumindest ein weiteres Mal, vorzugsweise wiederholt, misst, die sich aus den Messwerten jeweils ergebenden Parameter ermittelt und die jeweils aktuellen Parameter zur Aktualisierung des Parametersatzes verwendet.

Außerdem kann die Auswerteinrichtung auch derart ausgestaltet sein, dass sie mit den Strom- und Spannungswerten an der elektrischen Verbindungsstelle zwischen dem Streckenkabel und dem Statorabschnitt während des Betriebs der Magnetschwebebahn die Position eines Fahrzeugs auf dem Statorabschnitt bestimmt. Zusätzlich kann sie zur Bestimmung der Position des Fahrzeugs auch die Stromwerte an der Sternpunktseite des Statorabschnitts heranziehen.

Als Erfindung wird darüber hinaus eine Magnetschwebebahn mit einer Vielzahl an Streckenabschnitten angesehen, wobei zumindest einer der Streckenabschnitte, vorzugsweise alle Streckenabschnitte, jeweils mit einer individuellen, dezentralen Anordnung - wie beschrieben - zum Ermitteln eines Parametersatzes ausgestattet ist und wobei für jeden mit einer dezentralen Anordnung versehenen Streckenabschnitt jeweils der Schubkraftstrom des Streckenabschnitts unter Heranziehung seines dezentral ermittelten Parametersatzes ermittelt wird.

Als selbständige Erfindung wird darüber hinaus eine Anordnung und ein Verfahren zum Orten eines Fahrzeugs auf einem Streckenabschnitt einer Magnetschwebebahn angesehen, und zwar unabhängig davon, wie die Parameter bzw. Parametersätze für die Magnetschwebebahn ermittelt worden sind.

Als selbständige Erfindung wird darüber hinaus eine Anordnung und ein Verfahren zum Einstellen des Schubkraftstromes für ein auf einem Streckenabschnitt einer Magnetschwebebahn befindliches Fahrzeug angesehen, bei dem der Sternpunktstrom des Statorabschnitts als Statorstrom unterhalb des Fahrzeugs angesehen und zum Einstellen des Schubkraftstromes verwendet wird.

Die Erfindung wird nachfolgend anhand von Ausführungsbeispielen näher erläutert; dabei zeigen beispielhaft

Figur 2 ein Ausführungsbeispiel für eine erfindungsgemä- ße Anordnung, anhand derer auch das erfindungs- gemäße Verfahren beispielhaft erläutert wird,

Figur 3 allgemeine Erläuterungen zur Vierpoltheorie,

Figur 4 die Vierpoltheorie angewandt auf die Anordnung gemäß der Figur 2 und

Figur 5 schematisch die Ortsbestimmung eines Fahrzeugs, das sich auf einem Statorabschnitt der Anordnung gemäß der Figur 2 befindet.

In den Figuren 1 bis 5 werden aus Gründen der Übersichtlichkeit für identische oder vergleichbare Komponenten dieselben Bezugszeichen verwendet.

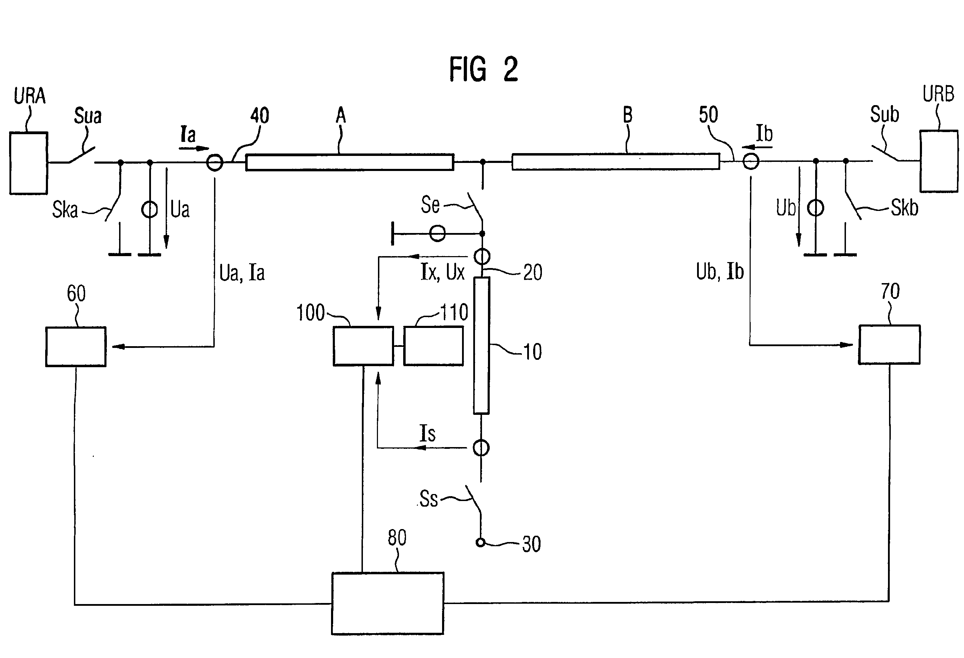

In der Figur 2 ist ein Ausführungsbeispiel für eine erfindungsgemäße Anordnung gezeigt. Diese Anordnung weist in Übereinstimmung mit der Anordnung gemäß der Figur 1 einen Statorabschnitt 10, ein Streckenkabel A, ein weiteres Streckenkabel B, mehrere Schalter Se, Ss, Sua, Ska, Sub und Skb, eine Umrichtereinrichtung URA, eine weitere Umrichtereinrichtung URB, eine umrichterbezogene Messeinrichtung 60, eine weitere umrichterbezogene Messeinrichtung 70 sowie eine Stromregelung 80 für die Magnetschwebebahn auf.

Zusätzlich ist bei der Anordnung gemäß der Figur 2 eine statorbezogene, mobile oder stationäre Messeinrichtung vorhanden, die mit dem Bezugszeichen 100 bezeichnet ist und eingangsseitig elektrisch an die Verbindungsstelle 20 zwischen den beiden Streckenkabeln A und B und dem Statorabschnitt 10 sowie an die Sternpunktseite 30 des Statorabschnitts angeschlossen ist. Ausgangsseitig steht die statorbezogene Messeinrichtung 100 mit einer Auswerteinrichtung 110 in Verbindung. Die statorbezogene Messeinrichtung 110 ist derart ausgestaltet, dass sie während ihres Betriebs die Strom- und Spannungswerte Ix, Ux an der Verbindungsstelle 20 zwischen den Streckenkabeln A, B und dem Statorabschnitt 10 sowie die Sternpunktstromwerte Is an der Sternpunktseite 30 misst und diese zur Auswerteinrichtung 110 übermittelt.

Bei dem Ausführungsbeispiel gemäß der Figur 2 steht die Auswerteinrichtung 110 mit den beiden umrichterbezogenen Messeinrichtungen 60 und 70 nur mittelbar über die statorbezogene Messeinrichtung 100 in Verbindung, so dass die umrichterbezogenen Messergebnisse Ia, Ib, Ua, Ub der umrichterbezogenen Messeinrichtungen 60 und 70 nur über die statorbezogene Messeinrichtung 100 zur Auswerteinrichtung 110 gelangen können. Alternativ kann die Auswerteinrichtung 110 auch an eine der beiden umrichterbezogenen Messeinrichtungen 60 oder 70 angeschlossen sein und über diese die Messergebnisse der übrigen Messeinrichtungen erhalten. Ebenso ist es möglich, die Auswerteinrichtung 110 jeweils mit allen Messeinrichtungen 60, 70 und 100 direkt zu verbinden, so dass eine unmittelbare Übertragung der Messergebnisse möglich ist.

Die Anordnung gemäß der Figur 2 lässt sich beispielsweise wie folgt betreiben:

Mit der umrichterbezogenen Messeinrichtung 60 werden der in das Streckenkabel A hineinfließende Strom Ia und die am Streckenkabel A anliegende Spannung Ua gemessen. Mit der weiteren umrichterbezogenen Messeinrichtung 70 wird der in das weitere Streckenkabel B hineinfließende Strom Ib und die am weiteren Streckenkabel B anliegende Spannung Ub gemessen. Mit der statorbezogenen Messeinrichtung 100 werden der Strom Ix und die Spannung Ux an der elektrischen Verbindungsstelle 20 zwischen den Streckenkabeln A, B und dem Statorabschnitt 10 sowie der Strom Is an der Sternpunktseite des Statorabschnitts 10 gemessen.

Die Auswerteinrichtung 110 ermittelt mit diesen Messergebnissen die elektrischen Parameter der beiden Streckenkabel A und B sowie die des Statorabschnitts 10 unter Heranziehung der Vierpoltheorie, wie nachfolgend im Detail erläutert wird.

Die elektrischen Eigenschaften eines langen Streckenkabels bzw. eines langen Statorabschnitts können gemäß Vierpoltheorie mathematisch wie folgt dargestellt werden:

$$\begin{pmatrix} I_1 \\ I_2 \end{pmatrix} = \begin{pmatrix} Y_{11} & Y_{21} \\ Y_{21} & Y_{22} \end{pmatrix} \begin{pmatrix} U_1 \\ U_2 \end{pmatrix} \qquad \text{Gleichung 1}$$

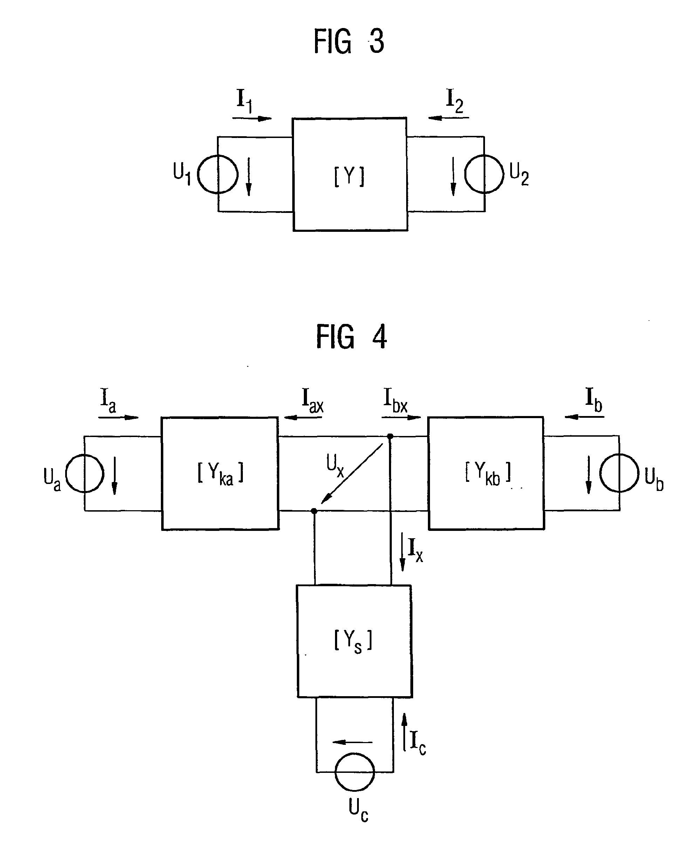

Die Spannungen U1 und U2 sind von Natur aus die Anregungen und die Ströme I1 und I2 sind die Antworten darauf. Die Spannungen und die Ströme sind komplex und können z.B. in $\alpha\beta$-Darstellung, die aus der dreiphasigen Systemdarstellung (R, S und T) abgeleitet werden kann, dargestellt werden. $Y_{ij}$ sind Admittanzen, die von der Frequenz abhängig sind (s-Domain nach Laplace). Schematisch kann die Vierpoltheorie wie in Figur 3 dargestellt visualisiert werden. Die Leitwertmatrix wird als [Y] bezeichnet. Die Struktur der Leitwertmatrix eines Streckenkabels und eines Statorabschnitts mit einer Länge L sind dabei identisch:

Für die Diagonal-Admittanz gilt:

$$Y_{11} = Y_{22} = Y_D = \frac{1}{Z_w \tanh(\gamma L)} \qquad \text{Gleichung 2}$$

Für die Quer-Admittanz gilt:

$$Y_{12} = Y_{21} = Y_C = -\frac{1}{Z_w \sinh(\gamma L)} \qquad \text{Gleichung 3}$$

Die Leitwertmatrix eines Streckenkabels bzw. eines Statorabschnitts ist gemäß Gleichung 2 und 3 vollkommen symmetrisch.

$Z_w$ bildet die Wellenimpedanz, mit

$$Z_w = \sqrt{\frac{R' + sL'}{G' + sC'}} \qquad \text{Gleichung 4}$$

und $\gamma$ ist die Ausbreitungskonstante:

$$\gamma = \sqrt{(R' + sL')(G' + sC')} \, .$$ Gleichung 5

Hier sind:

- R' der Widerstandsbelag ($\Omega$/m),
- L' der Induktivitätsbelag (H/m),
- G' der Ableitungsbelag($\Omega^{-1}$/m) und
- C' der Kapazitätsbelag (F/m).

Wichtige Eigenschaften der Gleichungen 2 und 3 ergeben sich gemäß:

$$Y_D{}^2 - Y_C{}^2 = \frac{1}{Z_w{}^2} \Rightarrow Z_w = \frac{1}{\sqrt{Y_D{}^2 - Y_C{}^2}}$$ Gleichung 6

$$\frac{Y_D}{Y_C} = -\cosh(\gamma L) \Rightarrow \gamma = \frac{1}{L}\mathrm{acosh}(-\frac{Y_D}{Y_C})$$ Gleichung 7

Aus $Y_D$ und $Y_C$ sind $Z_w$ und $\gamma$ abzuleiten.
Der Impedanzbelag wird auf folgende Weise berechnet:

$$Z = \gamma . Z_w = R' + sL'$$ Gleichung 8

Der Admittanzbelag wird folgendermaßen berechnet:

$$Y = \frac{\gamma}{Z_w} = G' + sC'$$ Gleichung 9

Mit $s = j\omega$ kann man aus Gleichung 6 und Gleichung 7 weiterhin folgende Beziehungen ableiten:
Der Widerstandsbelag ist der reelle Teil des Impedanzbelags:

$$R' = \mathrm{Re}(Z)$$ Gleichung 10

Der Induktivitätsbelag ist der imaginäre Teil des Impedanzbelags:

$$L' = \frac{1}{\omega}\mathrm{Im}(Z)$$ Gleichung 11

Der Ableitungsbelag ist der reelle Teil des Admittanzbelags:

$$G' = \mathrm{Re}(Y) \qquad\qquad \text{Gleichung 12}$$

Der Kapazitätsbelag ist der imaginäre Teil des Admittanzbelags:

$$C' = \frac{1}{\omega}\mathrm{Im}(Y) \qquad\qquad \text{Gleichung 13}$$

Wenn die Kennlinien der Diagonal- und der Quer-Admittanz eines Streckenkabels bzw. eines Statorabschnitts bekannt sind (als Funktion von der Frequenz), dann sind auch die Kennlinien der elektrischen Beläge R', L', G' und C' bekannt, sofern die Länge L des Streckenkabels bzw. des Statorabschnitts bekannt ist, weil sie beispielsweise vorab gemessen worden ist.

Die Kennlinien der Diagonal- und der Quer-Admittanz als Funktion von der Frequenz können mittels verschiedener Messungen (z. B. Spannungserregungen während der Inbetriebsetzung) als Funktion von der Frequenz ermittelt werden.

Der Zweck der Ermittlung von R', L', G' und C' besteht darin, Modelle für die beiden Streckenkabel A, B und den Statorabschnitt 10 abzuleiten. Die Modelle werden beispielsweise für die Stromregelung der Magnetschwebebahn verwendet.

Nachfolgend wird die Parameterermittlung während der Inbetriebsetzung einer Magnetschwebebahn (ohne Fahrzeug) am Beispiel der Anordnung gemäß der Figur 2 näher erläutert.

Die Vierpoldarstellung, wie sie anhand der Figur 3 allgemein erläutert wurde, wird dabei auf die Anordnung gemäß der Figur 2 angewandt; dies zeigt die Figur 4. Die Schalter Se, Ss, Sua, Ska, Sub und Skb sind in der Figur 4 nicht dargestellt; die Schalter Se und Ss werden als eingeschaltet angenommen.

Außerdem wird angenommen, dass der Statorstrom Ic auf dem Statorabschnitt 10 dem Sternpunktstrom Is des Statorabschnitts 10 entspricht; diese Näherung gilt für kleine Frequenzen bis 350 Hertz sehr genau.

Es gelten somit die folgenden Vierpol-Gleichungen:

Streckenkabel A:

$$\begin{pmatrix} I_a \\ I_{ax} \end{pmatrix} = \begin{pmatrix} Y_{Da} & Y_{Ca} \\ Y_{Ca} & Y_{Da} \end{pmatrix}\begin{pmatrix} U_a \\ U_x \end{pmatrix} \qquad\qquad \text{Gleichung 14}$$

Streckenkabel B:

$$\begin{pmatrix} I_b \\ I_{bx} \end{pmatrix} = \begin{pmatrix} Y_{Db} & Y_{Cb} \\ Y_{Cb} & Y_{Db} \end{pmatrix}\begin{pmatrix} U_b \\ U_x \end{pmatrix} \qquad\qquad \text{Gleichung 15}$$

Statorabschnitt:

$$\begin{pmatrix} I_x \\ I_c \end{pmatrix} = \begin{pmatrix} Y_{Ds} & Y_{Cs} \\ Y_{Cs} & Y_{Ds} \end{pmatrix}\begin{pmatrix} U_x \\ U_c \end{pmatrix} \qquad\qquad \text{Gleichung 16}$$

$$I_x = -(I_{ax} + I_{bx}) \qquad\qquad \text{Gleichung 17}$$

Die Ermittlung der Werte R', L', G' und C' des Statorabschnitts 10 mit der Auswerteinrichtung 110 erfolgt während der Inbetriebsetzung (ohne Fahrzeug) über eine Einspeisung von der Umrichtereinrichtung URA und/oder von der weiteren Umrichtereinrichtung URB. Wenn die Schalter Se und Ss geschlossen sind und sich kein Fahrzeug auf dem Statorabschnitt 10 befindet, so folgt aus Gleichung 16:

$$I_x = Y_{Ds}U_x \Rightarrow Y_{Ds} = \left(\frac{I_x}{U_x}\right)_{Uc=0} = \frac{1}{Z_{ws}\tanh(\gamma_s L_s)} \qquad \text{Gleichung 18}$$

$$I_c = Y_{Cs}U_x \Rightarrow Y_{Cs} = \left(\frac{I_c}{U_x}\right)_{Uc=0} = -\frac{1}{Z_{ws}\sinh(\gamma_s L_s)} \qquad \text{Gleichung 19}$$

Gemäß Gleichung 6 bis 13 sind somit die Werte $R_s'$, $L_s'$, $G_s'$ und $C_s'$ des Statorabschnitts eindeutig analytisch berechenbar.

Der Streu-Widerstand des Statorabschnitts wird wie folgt berechnet:

$$R_\sigma = R_s'.L_s \qquad\qquad \text{Gleichung 20}$$

Der Streu-Induktivität des Statorabschnitts wird wie folgt berechnet:

$$L_\sigma = L_s'.L_s \qquad\qquad \text{Gleichung 21}$$

Der Streu-Widerstand $R_\sigma$ und die Streu-Induktivität $L_\sigma$ können beispielsweise für die Berechnung bzw. Ermittlung der Polradspannung UC während des Betriebs des Statorabschnitts 10 mit einem Fahrzeug verwendet werden; dies wird weiter unten näher erläutert.

Die Ermittlung der Werte R', L', G' und C' des Streckenkabels A und B während der Inbetriebsetzung (ohne Fahrzeug) wird beispielsweise folgendermaßen durchgeführt:

Die Schalter Sub und Ska werden geöffnet und der Schalter Sua geschlossen; die Einspeisung erfolgt über die Umrichtereinrichtung URA:

1. Wenn der Schalter Skb geschlossen ist (KurzschlussMessung) gilt $U_b$=0 und aus Gleichung 1 folgt:

$$I_b = Y_{Cb}U_x$$
$$\Rightarrow Y_{Cb} = \left(\frac{I_b}{U_x}\right)_{Ub=0} = -\frac{1}{Z_{wb}\sinh(\gamma_b L_b)} \qquad \text{Gleichung 22}$$

2. Wenn der Schalter Skb geöffnet ist (Leerlauf-Messung) gilt $I_b$=0 und aus Gleichung 1 folgt:

$$I_b = 0 = Y_{Db}U_b + Y_{Cb}U_x$$
$$\Rightarrow \frac{Y_{Db}}{Y_{Cb}} = -\left(\frac{U_x}{U_b}\right)_{Ib=0} = -\cosh(\gamma_b L_b) \qquad \text{Gleichung 23}$$

Aus den Gleichungen 22 und 23 wird $Y_{Db}$ abgeleitet, so dass gemäß Gleichungen 6 bis 13 die Werte $R_b'$, $L_b'$, $G_b'$ und $C_b'$ des Streckenkabels B eindeutig analytisch bestimmt werden können, wenn dessen Länge $L_b$ bekannt ist.

Durch eine entsprechende Messung von der weiteren Umrichtereinrichtung URB aus können die Parameter des Streckenkabels A ermittelt werden, wenn dessen Länge $L_a$ bekannt ist. Vorzugsweise sind die beiden Streckenkabel A und B identisch.

Die einzige Größe, die in der Gleichung 14 nicht direkt messbar ist, ist der Strom $I_{ax}$. Dieser ist jedoch dennoch bestimmbar, weil er aus den Gleichungen 15 und 17 abgeleitet werden kann:

$$I_{ax} = -(I_x + I_{bx}) = -(I_x + Y_{Db}.U_x + Y_{Cb}.U_b) \qquad \text{Gleichung 24}$$

Die Admittanzen $Y_{Db}$ und $Y_{Cb}$ werden vorher aus den Gleichungen 22 und 23 berechnet. Da die Ströme und die Spannungen in der Gleichung 12 jetzt bekannt sind, sind die Komponenten der Leitwertmatrix $[Y_a]$, nämlich $Y_{Da}$ und $Y_{Ca}$ ebenfalls bestimmbar. Damit ergeben sich aus den Gleichungen 6 bis 13 auch die Werte $R_a'$, $L_a'$, $G_a'$ und $C_a'$ des Streckenkabels A.

Mit den Werten R', L', G' und C' kann nun ein mathematisches Modell für die beiden Streckenkabel A und B und für den Statorabschnitt 10 erstellt werden, das zur Stromregelung für die Magnetschwebebahn verwendet werden kann.

Unter Umständen kann die Konfiguration des Streckenkabels komplizierter sein, als dies in den Figuren 1 und 2 dargestellt ist. Trotzdem ist die Vierpoltheorie immer gültig und anwendbar. Beispielsweise kann die Symmetrie gemäß Gleichung 2 nicht mehr erfüllt sein ($Y_{11} \neq Y_{22}$). Die Gleichung 3, die besagt, dass der Quer-Leitwert identisch ist, bleibt aber gültig ($Y_{12} = Y_{21}$). Allgemein gelten immer folgende Gleichungen:

$$\begin{pmatrix} I_a \\ I_{ax} \end{pmatrix} = \begin{pmatrix} Y_{Daa} & Y_{Ca} \\ Y_{Ca} & Y_{Dax} \end{pmatrix} \begin{pmatrix} U_a \\ U_x \end{pmatrix} \qquad \text{Gleichung 25}$$

$$\begin{pmatrix} I_b \\ I_{bx} \end{pmatrix} = \begin{pmatrix} Y_{Dbb} & Y_{Cb} \\ Y_{Cb} & Y_{Dbx} \end{pmatrix} \begin{pmatrix} U_b \\ U_x \end{pmatrix} \qquad \text{Gleichung 26}$$

$$\begin{pmatrix} I_x \\ I_c \end{pmatrix} = \begin{pmatrix} Y_{Ds} & Y_{Cs} \\ Y_{Cs} & Y_{Ds} \end{pmatrix} \begin{pmatrix} U_x \\ U_c \end{pmatrix} \qquad \text{Gleichung 27}$$

$$I_x = -(I_{ax} + I_{bx}) \qquad \text{Gleichung 28}$$

Die Parameter sind mittels der Messwerte der drei Messeinrichtungen 60, 70 und 100 somit eindeutig bestimmbar.

Mit einem darauf befindlichen Fahrzeug verhält sich der Statorabschnitt 10 ein wenig anders als während der Inbetriebsetzung ohne Fahrzeug. Die elektrischen Eigenschaften des Statorabschnitts 10 mit Fahrzeug können mit folgendem Modell für Frequenzen unterhalb von 350 Hz sehr genau annähert werden:

$$\begin{pmatrix} U_c \\ I_c \end{pmatrix} = \begin{pmatrix} 1 & -(R_\sigma + sL_\sigma) \\ sC(x) & -1 \end{pmatrix} \begin{pmatrix} U_x \\ I_x \end{pmatrix} \qquad \text{Gleichung 29}$$

Es gilt näherungsweise auch hier, dass der Statorstrom $I_c$ dem Sternpunktstrom $I_s$ des Statorabschnitts 10 näherungsweise entspricht (<350Hz),

$$I_c = I_s \qquad \text{Gleichung 30}$$

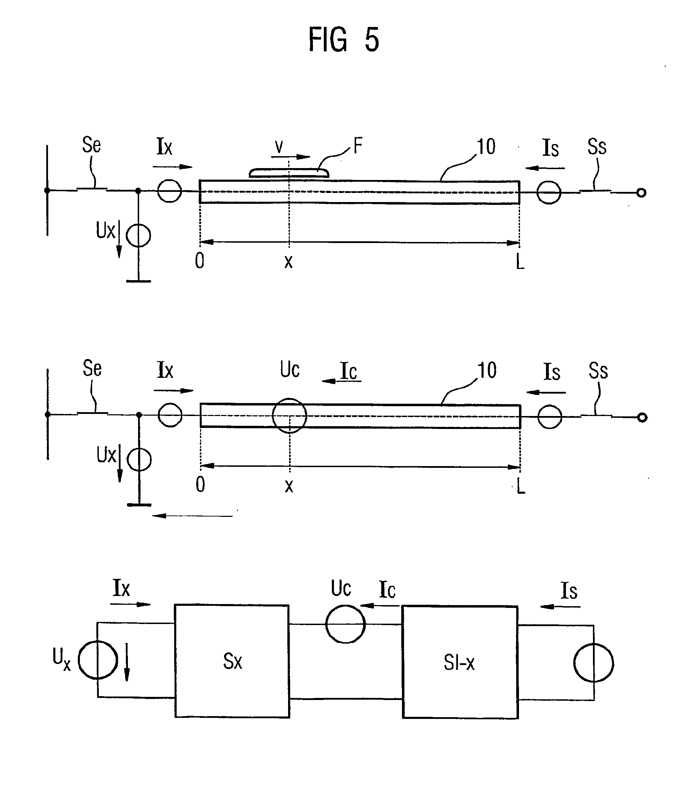

Die Figur 5 zeigt den Statorabschnitt 10 mit einem mit einer Geschwindigkeit v fahrenden Fahrzeug F, das gerade eine relative Position x auf dem Statorabschnitt 10 einnimmt. Das Fahrzeug F kann elektrisch als eine punktförmige Spannung Uc dargestellt werden. Die punktförmige Spannung entspricht der Polradspannung Uc des Statorabschnitts und ist unmittelbar nicht messbar. Sie kann aber berechnet werden gemäß,

$$U_c = U_x - (R_\sigma + sL_\sigma).I_x \qquad\qquad \text{Gleichung 31}$$

Angenommen sei, dass $U_c$ eine reine sinusförmige Spannung bildet; in diesem Falle kann aus Gleichung 31 ein Oberschwingungsmodell des Statorabschnitts abgeleitet werden,

$$0 = U_{x,obsch} - (R_\sigma + sL_\sigma).I_{x,obsch}$$
$$\Rightarrow U_{x,obsch} = (R_\sigma + sL_\sigma)I_{x,obsch} \qquad\qquad \text{Gleichung 32}$$

Der Streu-Widerstand $R_\sigma$ und die Streu-Induktivität $L_\sigma$ können dann mittels dieses Oberschwingungsmodells ermittelt werden, wie dies in der Schrift "Sensorless Control of a 2.4 MW Linear Motor for launching roller-coasters" (EPE 2003 - Toulouse (ISBN: 90-75815-07-7), Autoren: Andre Veltman, Paul van der Hulst, Marco C.P. Jonker, Jan P. van Gurp) beschrieben ist.

Bei einer komplizierten Streckenkabel-Konfiguration kann mittels der Gleichlangen 25, 26 und 28 im Übrigen die folgende Beziehung abgeleitet werden:

$$\begin{pmatrix} I_a \\ I_b \\ I_x \end{pmatrix} = \begin{pmatrix} Y_{Daa} & 0 & Y_{Ca} \\ 0 & Y_{Cb} & Y_{Dbb} \\ -Y_{Dax} & -Y_{DBx} & -(Y_{Ca}+Y_{Cb}) \end{pmatrix} \begin{pmatrix} U_a \\ U_b \\ U_x \end{pmatrix} \qquad \text{Gleichung 33}$$

In der Gleichung 33 werden alle messbaren Größen ($I_a$, $I_b$, $I_x$, $U_a$, $U_b$ und $U_x$) in einer einzigen Gleichung vereinigt. Die Leitwertmatrix ist jetzt eine 3x3 Matrix (3 Gleichungen). Die sechs unbekannten Leitwerte ($Y_{Daa}$, $Y_{Dax}$, $Y_{Ca}$, $Y_{Dbb}$, $Y_{DBx}$ und $Y_{Cb}$) können einfach ermittelt werden, da mindestens sechs Gleichungen zur Verfügung stehen. Die sechs Gleichungen können zum Beispiel aufgestellt werden, indem man die Ströme und die Spannungen zu zwei unterschiedlichen Abtastzeitpunkten misst, da sich die Ströme und die Spannungen über die Zeit ändern. Messungen zu mehreren Abtastzeitpunkten verbessern im Übrigen statistisch auch die Qualität Parameterschätzung.

Das Problem in Gleichung 36 lässt sich auch verallgemeinern mit folgender Formulierung:

$$\mathbf{I} = \mathbf{YU} \qquad\qquad \text{Gleichung 34}$$

oder,

$$\mathbf{e} = \mathbf{I} - \hat{\mathbf{Y}}\mathbf{U} \qquad\qquad \text{Gleichung 35}$$

Hier bezeichnet I einen Stromvektor, U einen Spannungsvektor, e einen Fehlervektor (Vektor mit der Dimension 3x1), Y eine echte Leitwertmatrix und $\hat{\mathbf{Y}}$ eine geschätzte Leitwertmatrix (Matrix mit Dimension 3x3).

Eine Kostenfunktion J wird beispielsweise folgendermaßen definiert,

$$J = \sum_{i=1}^{N} \mathbf{e}^{\mathbf{T}}.\mathbf{e} = \sum_{i=1}^{N} (\mathbf{I} - \hat{\mathbf{Y}}\mathbf{U})^{T}.(\mathbf{I} - \hat{\mathbf{Y}}\mathbf{U}) \qquad\qquad \text{Gleichung 36}$$

Diese Formulierung ist eine bekannte Problemstellung (nach Gauß), wobei N die Anzahl der Messungen zu mehreren Abtastzeiten bezeichnet. Es gibt viele Verfahren, um die Gleichung 36 zu lösen, indem beispielsweise J minimiert wird.

Die Position x des Fahrzeugs F gemäß der Figur 5 kann im Übrigen ebenfalls bestimmt werden, und zwar gemäß:

$$x = \frac{1}{j\omega C'_s} \frac{Ix + Is}{Ux} \qquad \text{Gleichung 37}$$

wobei Cs' den Kapazitätsbelag des Statorabschnitts 10 bezeichnet. Die Gleichung 37 ist während des Betriebs der Magnetschwebebahn anwendbar, wenn die beiden Schalter Se und Ss geschlossen sind.

Wenn die beiden Schalter Se und Ss geöffnet sind, lässt sich die Position x über den Polradwinkel Φ der Spannung Uc bestimmen, indem der Phasenwinkel der Spannung Ux gemessen wird; denn Ux und Uc weisen die gleichen Phasenwinkel auf und sind demgemäß kollinear:

$$Uc = (1 - \frac{x}{Ls})Ux$$

Es wird in diesem Falle also der Phasenwinkel von Ux gemessen, mit dem Phasenwinkel von Ux wird der Polradwinkel Φ der Spannung Uc bestimmt und mit dem Polradwinkel Φ wird der Ort des Fahrzeugs errechnet.

Bezugszeichenliste

| | |
|---|---|
| 10 | Statorabschnitt |
| 20 | Anschluss |
| 30 | Sternpunkt |
| 40 | Einspeiseanschluss |
| 50 | Einspeiseanschluss |
| 60 | umrichterbezogene Messeinrichtung |
| 70 | weitere umrichterbezogene Messeinrichtung |
| 80 | Stromregelung |
| 90 | Auswerteinrichtung |
| 100 | statorbezogene Messeinrichtung |
| 110 | Auswerteinrichtung |
| A, B | Streckenkabel |
| Se | Schalter |
| Ss | Schalter |
| Sua | Schalter |
| Ska | Schalter |
| Sub | Schalter |
| Skb | Schalter |
| URA | Umrichtereinrichtung |
| URB | weitere Umrichtereinrichtung |

**Patentansprüche**

1. Verfahren zum Ermitteln eines Parametersatzes, der elektrische Parameter eines Streckenabschnitts einer Magnetschwebebahn beschreibt, wobei der Streckenabschnitt einen einen Antriebsabschnitt der Magnetschwebebahn bildenden Statorabschnitt (10) und ein Streckenkabel (A, B), das den Statorabschnitt mit einer zugeordneten Umrichtereinrichtung (URA, URB) verbindet, umfasst, wobei bei dem Verfahren

- die Strom- und Spannungswerte (Ua, Ia, Ub, IB) an der elektrischen Verbindungsstelle (40, 50) zwischen dem Streckenkabel und der Umrichtereinrichtung gemessen werden und
- mit diesen Messwerten die Parameter des Parametersatzes ermittelt werden und damit der Parametersatz gebildet wird,

**dadurch gekennzeichnet, dass**

- zusätzlich die Strom- und Spannungswerte (Ux, Ix) an der elektrischen Verbindungsstelle (20) zwischen dem Streckenkabel und dem Statorabschnitt sowie die Stromwerte (Is) an der Sternpunktseite (30) des Statorabschnitts gemessen werden, wenn der Statorabschnitt mit dem Streckenkabel elektrisch verbunden ist, und
- diese zusätzlichen Messwerten beim Ermitteln der Parameter ebenfalls berücksichtigt werden.

2. Verfahren nach Anspruch 1,
   **dadurch gekennzeichnet, dass** der Statorabschnitt über ein weiteres Streckenkabel (B) mit einer weiteren Umrichtereinrichtung (URB) verbunden ist und die Strom- und Spannungswerte (Ib, Ub) an der elektrischen Verbindungsstelle (50) zwischen dem weiteren Streckenkabel und der weiterem Umrichtereinrichtung ebenfalls gemessen werden und diese Messwerte beim Ermitteln der Parameter zusätzlich berücksichtigt werden.

3. Verfahren nach Anspruch 1 oder 2,
   **dadurch gekennzeichnet, dass** als Parameter zumindest einer der folgenden Parameter ermittelt wird: der elektrische Widerstand (R), die Induktivität (L), die Kapazität (C), der elektrische Widerstandsbelag (R'), der Induktivitätsbelag (L'), der Ableitungsbelag (Y'), der Kapazitätsbelag (C') und/oder der Leitwert (Y), sei es des Streckenkabels (A), des weiteren Streckenkabels (B) und/oder des Statorabschnitts (10).

4. Verfahren nach einem der voranstehenden Ansprüche, **dadurch gekennzeichnet, dass** die Strom- und Spannungswerte an der elektrischen Verbindungsstelle zwischen dem Streckenkabel und der Umrichtereinrichtung und die Strom- und Spannungswerte an der elektrischen Verbindungsstelle zwischen dem Streckenkabel und dem Statorabschnitt jeweils dreiphasig gemessen und phasenleiterindividuell ausgewertet werden.

5. Verfahren nach einem der voranstehenden Ansprüche, **dadurch gekennzeichnet, dass** die Strom- und Spannungswerte an der elektrischen Verbindungsstelle zwischen dem Streckenkabel und dem Statorabschnitt sowie die Stromwerte an der Sternpunktseite des Statorabschnitts mit einer mobilen Messeinrichtung (100) erfasst werden und zu einer mobilen oder stationären Auswerteinrichtung (110) übertragen werden, mit der die Parameter ermittelt werden.

6. Verfahren nach einem der voranstehenden Ansprüche 1-4, **dadurch gekennzeichnet, dass** die Strom- und Spannungswerte an der elektrischen Verbindungsstelle zwischen dem Streckenkabel und dem Statorabschnitt sowie die Stromwerte an der Sternpunktseite des Statorabschnitts mit einer stationären Messeinrichtung (100) erfasst werden und zu einer mobilen oder stationären Auswerteinrichtung (110) übertragen werden, mit der die Parameter ermittelt werden.

7. Verfahren nach einem der voranstehenden Ansprüche, **dadurch gekennzeichnet, dass**

   - nach dem Bestimmen der Parameter die Strom- und Spannungswerte an der elektrischen Verbindungsstelle zwischen dem Streckenkabel und der Umrichtereinrichtung, die Strom- und Spannungswerte an der elektrischen Verbindungsstelle zwischen dem Streckenkabel und dem Statorabschnitt sowie die Stromwerte an der Sternpunktseite des Statorabschnitts während des Betriebs der Magnetschwebebahn zumindest ein weiteres Mal, vorzugsweise wiederholt, gemessen werden,
   - die sich aus den Messwerten jeweils ergebenden Parameter ermittelt werden und
   - die jeweils aktuellen Parameter zur Aktualisierung des Parametersatzes verwendet werden.

8. Verfahren nach einem der voranstehenden Ansprüche, **dadurch gekennzeichnet, dass** die Strom- und Spannungswerte an der elektrischen Verbindungsstelle zwischen dem Streckenkabel und dem Statorabschnitt dazu verwendet werden, während des Betriebs der Magnetschwebebahn die Position (x) eines Fahrzeugs (F) auf dem Statorabschnitt zu bestimmen.

9. Verfahren nach Anspruch 8,
   **dadurch gekennzeichnet, dass** zur Bestimmung der Position des Fahrzeugs zusätzlich die Stromwerte (Is) an der Sternpunktseite des Statorabschnitts herangezogen werden.

**10.** Verfahren nach einem der voranstehenden Ansprüche, **dadurch gekennzeichnet, dass** als Statorstrom (Ic) des Statorabschnitts (10) der gemessene Sternpunktstrom (Is) verwendet wird.

**11.** Verfahren nach einem der voranstehenden Ansprüche, **dadurch gekennzeichnet, dass** die Parameter zur Einstellung des Schubkraftstromes für ein auf dem Statorabschnitt befindliches Fahrzeug (F) verwendet werden.

**12.** Anordnung zum Ermitteln eines Parametersatzes, der elektrische Parameter eines Streckenabschnitts einer Magnetschwebebahn beschreibt, wobei der Streckenabschnitt einen einen Antriebsabschnitt der Magnetschwebebahn bildenden Statorabschnitt (10) und ein Streckenkabel (A, B), das den Statorabschnitt mit einer zugeordneten Umrichtereinrichtung (URA, URB) verbindet, umfasst,

 - wobei die Anordnung eine umrichterbezogene Messeinrichtung (60, 70) aufweist, die an die elektrische Verbindungsstelle (40, 50) zwischen dem Streckenkabel und der Umrichtereinrichtung angeschlossen ist und während ihres Betriebs die Strom- und Spannungswerte an der Verbindungsstelle misst, und
 - wobei die Anordnung eine Auswerteinrichtung (110) aufweist, die mit der umrichterbezogenen Messeinrichtung in Verbindung steht und mit den Messwerten der umrichterbezogenen Messeinrichtung die Parameter des Parametersatzes ermittelt und damit den Parametersatz bildet,

 **dadurch gekennzeichnet, dass**

 - die Anordnung zusätzlich eine statorbezogene Messeinrichtung (100) aufweist, die eingangsseitig an die elektrische Verbindungsstelle (20) zwischen dem Streckenkabel und dem Statorabschnitt sowie an die Sternpunktseite (30) des Statorabschnitts angeschlossen ist und ausgangsseitig mit der Auswerteinrichtung (110) mittelbar oder unmittelbar in Verbindung steht,
 - wobei die statorbezogene Messeinrichtung derart ausgestaltet ist, dass sie während ihres Betriebs die Strom- und Spannungswerte an der Verbindungsstelle zwischen dem Streckenkabel und dem Statorabschnitt sowie die Stromwerte an der Sternpunktseite misst und diese zur Auswerteinrichtung übermittelt, wobei
 - die Auswerteinrichtung derart ausgestaltet ist, dass sie die Messwerte der statorbezogenen Messeinrichtung bei der Ermittlung der Parameter zusätzlich berücksichtigt und die Messungen durchführt, wenn der Statorabschnitt mit dem Streckenkabel elektrisch verbunden ist.

**13.** Anordnung nach Anspruch 12,
 **dadurch gekennzeichnet, dass** die Anordnung eine weitere umrichterbezogene Messeinrichtung (70) aufweist, die eingangsseitig an die elektrische Verbindungsstelle (50) zwischen einem weiteren Streckenkabel (B) und einer weiteren Umrichtereinrichtung (URB) und ausgangsseitig an die Auswerteinrichtung (110) mittelbar oder unmittelbar angeschlossen ist und die derart ausgestaltet ist, dass sie während ihres Betriebs die Strom- und Spannungswerte an der Verbindungsstelle zwischen dem weiteren Streckenkabel und der weiteren Umrichtereinrichtung misst und diese zur Auswerteinrichtung übermittelt.

**14.** Anordnung nach Anspruch 12 oder 13,
 **dadurch gekennzeichnet, dass** die statorbezogene Messeinrichtung (100) und/oder die Auswerteinrichtung durch eine mobile Einheit gebildet ist.

**15.** Anordnung nach einem der voranstehenden Ansprüche 12 oder 13,
 **dadurch gekennzeichnet, dass** die statorbezogene Messeinrichtung (100) und/oder die Auswerteinrichtung durch eine stationäre Einheit gebildet ist.

**16.** Anordnung nach einem der voranstehenden Ansprüche 12-15, **dadurch gekennzeichnet, dass** die Auswerteinrichtung derart ausgestaltet ist, dass

 - sie nach dem Bestimmen der Parameter die Strom- und Spannungswerte an der elektrischen Verbindungsstelle zwischen dem Streckenkabel und der Umrichtereinrichtung, die Strom-und Spannungswerte an der elektrischen Verbindungsstelle zwischen dem Streckenkabel und dem Statorabschnitt sowie die Stromwerte an der Sternpunktseite des Statorabschnitts während des Betriebs der Magnetschwebebahn zumindest ein weiteres Mal, vorzugsweise wiederholt, misst,
 - die sich aus den Messwerten jeweils ergebenden Parameter ermittelt und
 - die jeweils aktuellen Parameter zur Aktualisierung des Parametersatzes verwendet.

**17.** Anordnung nach einem der voranstehenden Ansprüche 12-16, **dadurch gekennzeichnet, dass** die Auswerteinrichtung derart ausgestaltet ist, dass sie mit den Strom- und Spannungswerten an der elektrischen Verbindungsstelle zwischen dem Streckenkabel und dem Statorabschnitt während des Betriebs der Magnetschwebebahn die Position eines Fahrzeugs auf dem Statorabschnitt bestimmt.

**18.** Anordnung nach Anspruch 17,
**dadurch gekennzeichnet, dass** die Auswerteinrichtung derart ausgestaltet ist, dass sie zur Bestimmung der Position des Fahrzeugs zusätzlich die Stromwerte an der Sternpunktseite des Statorabschnitts heranzieht.

**19.** Magnetschwebebahn mit einer Vielzahl an Streckenabschnitten,

- wobei zumindest einer der Streckenabschnitte, vorzugsweise alle Streckenabschnitte, jeweils mit einer individuellen, dezentralen Anordnung nach einem der voranstehenden Ansprüche zum Ermitteln eines Parametersatzes ausgestattet ist und
- wobei für jeden mit einer dezentralen Anordnung versehenen Streckenabschnitt jeweils der Schubkraftstrom des Streckenabschnitts unter Heranziehung seines dezentral ermittelten Parametersatzes ermittelt wird.

**Claims**

**1.** Method for determination of a parameter set which describes electrical parameters of a track section of a magnetic levitation railroad, wherein the track section comprises a stator section (10), which forms a drive section of the magnetic levitation railroad, and a track cable (A, B) which connects the stator section to an associated converter device (URA, URB), wherein, in the case of the method:

- the current and voltage values (Ua, Ia, Ub, IB) are measured at the electrical connection point (40, 50) between the track cable and the converter device, and
- these measured values are used to determine the parameters of the parameter set, and therefore to form the parameter set,
**characterized in that**
- in addition, the current and voltage values (Ux, Ix) are measured at the electrical connection point (20) between the track cable and the stator section, and the current values (Is) are measured on the star point side (30) of the stator section when the stator section is electrically connected to the track cable, and
- these additional measured values are likewise taken into account in determination of the parameters.

**2.** Method according to Claim 1,
**characterized in that** the stator section is connected via a further track cable (B) to a further converter device (URB), and the current and voltage values (Ib, Ub) are likewise measured at the electrical connection point (50) between the further track cable and the further converter device, and these measured values are additionally taken into account in determination of the parameters.

**3.** Method according to Claim 1 or 2,
**characterized in that** at least one of the following parameters is determined as a parameter: the electrical resistance (R), the inductance (L), the capacitance (C), the electrical resistance per unit length (R'), the inductance per unit length (L'), the susceptance per unit length (Y'), the capacitance per unit length (C') and/or the conductance (Y), be this of the track cable (A), of the further track cable (B) and/or of the stator section (10).

**4.** Method according to one of the preceding claims, **characterized in that** the current and voltage values are in each case measured on three phases at the electrical connection point between the track cable and the converter device, and the current and voltage values are in each case measured on three phases at the electrical connection point between the track cable and the stator section, and are evaluated on a phase-conductor-specific basis.

**5.** Method according to one of the preceding claims, **characterized in that** the current and voltage values are recorded at the electrical connection point between the track cable and the stator section, and the current values are recorded on the star point side of the stator section by means of a mobile measurement device (100), and are transmitted to a mobile or stationary evaluation device (110), by means of which the parameters are determined.

**6.** Method according to one of the preceding Claims 1-4, **characterized in that** the current and voltage values are recorded at the electrical connection point between the track cable and the stator section, and the current values are recorded on the star point side of the stator section by means of a stationary measurement device (100), and are transmitted to a mobile or stationary evaluation device (110), by means of which the parameters are determined.

7. Method according to one of the preceding claims, **characterized in that**

- after the determination of the parameters, the current and voltage values are measured at least one more time, preferably repeatedly, at the electrical connection point between the track cable and the converter device, the current and voltage values are measured at least one more time, preferably repeatedly, at the electrical connection point between the track cable and the stator section, and the current values are measured at least one more time, preferably repeatedly, on the star point side of the stator section during operation of the magnetic levitation railroad,
- the parameters which result from each of the measured values are determined, and
- the respectively up-to-date parameters are used to update the parameter set.

8. Method according to one of the preceding claims, **characterized in that** the current and voltage values at the electrical connection point between the track cable and the stator section are used to determine the position (x) of a vehicle (F) on the stator section during operation of the magnetic levitation railroad.

9. Method according to Claim 8, **characterized in that** the current values (Is) on the star point side of the stator section are additionally used for determination of the position of the vehicle.

10. Method according to one of the preceding claims, **characterized in that** the measured star point current (Is) is used as the stator current (Ic) of the stator section (10).

11. Method according to one of the preceding claims, **characterized in that** the parameters are used to adjust the thrust force current for a vehicle (F) which is located on the stator section.

12. Arrangement for determination of a parameter set which describes electrical parameters of a track section of a magnetic levitation railroad, wherein the track section comprises a stator section (10), which forms a drive section of the magnetic levitation railroad, and a track cable (A, B) which connects the stator section to an associated converter device (URA, URB),

- wherein the arrangement has a converter-related measurement device (60, 70) which is connected to the electrical connection point (40, 50) between the track cable and the converter device and measures the current and voltage values at the connection point during its operation, and
- wherein the arrangement has an evaluation device (110), which is connected to the converter-related measurement device and uses the measured values from the converter-related measurement device to determine the parameters of the parameter set, and therefore to form the parameter set, **characterized in that**
- the arrangement additionally has one stator-related measurement device (100) which is connected on the input side to the electrical connection point (20) between the track cable and the stator section and to the star point side (30) of the stator section, and is connected directly or indirectly on the output side to the evaluation device (110),
- wherein the stator-related measurement device is designed such that, during its operation, it measures the current and voltage values at the connection point between the track cable and the stator section and the current values on the star point side, and transmits these to the evaluation device, wherein
- the evaluation device is designed such that it additionally takes account of the measured values of the stator-related measurement device in the determination of the parameters and carries out the measurements when the stator section is electrically connected to the track cable.

13. Arrangement according to Claim 12, **characterized in that** the arrangement has a further converter-related measurement device (70), which is indirectly or directly connected on the input side to the electrical connection point (50) between a further track cable (B) and a further converter device (URB), and is indirectly or directly connected on the output side to the evaluation device (110), and is designed such that, during its operation, it measures the current and voltage values at the connection point between the further track cable and the further converter device, and transmits these to the evaluation device.

14. Arrangement according to Claim 12 or 13, **characterized in that** the stator-related measurement device (100) and/or the evaluation device are/is formed by a mobile unit.

15. Arrangement according to one of the preceding Claims 12 or 13, **characterized in that** the stator-related measurement device (100) and/or the evaluation device are/is formed by a stationary unit.

16. Arrangement according to one of the preceding Claims 12-15, **characterized in that** the evaluation device is designed such that,

- after determination of the parameters, it measures the current and voltage values at the electrical connection point between the track cable and the converter device, the current and voltage values at the electrical connection point between the track cable and the stator section, and the current values on the star point side of the stator section during operation of the magnetic levitation railroad, at least once more, and preferably repeatedly,
- it determines the parameters which result from each of the measured values, and
- uses the respectively up-to-date parameters to update the parameter set.

17. Arrangement according to one of the preceding Claims 12-16, **characterized in that** the evaluation device is designed such that it uses the current and voltage values at the electrical connection point between the track cable and the stator section during operation of the magnetic levitation railroad to determine the position of a vehicle on the stator section.

18. Arrangement according to Claim 17, **characterized in that** the evaluation device is designed such that it additionally uses the current values on the star point side of the stator section to determine the position of the vehicle.

19. Magnetic levitation railroad having a multiplicity of track sections,

- wherein at least one of the track sections, preferably all of the track sections, is or are each equipped with an individual, local arrangement according to one of the preceding claims in order to determine a parameter set, and
- wherein the thrust force current of the track section is in each case determined for each track section which is provided with a local arrangement, using its locally determined parameter set.

## Revendications

1. Procédé de détermination d'un jeu de paramètres, qui décrit des paramètres électriques d'une section de voie d'un réseau à sustentation magnétique, dans lequel la section de voie comprend une section ( 10 ) de stator, formant une section d'entraînement du réseau à sustentation magnétique et un câble ( A, B ) de voie, qui relie la section de stator à un dispositif ( URA, URB ) de convertisseur associé, procédé dans lequel

- on mesure les valeurs ( Ua, Ia, Ub, IB ) de courant et de tension au point ( 45, 50 ) de liaison électrique entre le câble de voie et le dispositif de convertisseur et
- on détermine, par ces valeurs, les paramètres du jeu de paramètres et on forme ainsi le jeu de paramètres, **caractérisé en ce que**
- on mesure supplémentairement les valeurs Ux, Ix ) de courant et de tension au point ( 20 ) de liaison électrique entre le câble de voie et la section de stator, ainsi que les valeurs ( Is ) de courant du côté ( 30 ) du point neutre de la section de stator, lorsque la section de stator est reliée électriquement au câble de voie, et
- on tient compte également de ces valeurs de mesure supplémentaires, lors de la détermination des paramètres.

2. Procédé suivant la revendication 1,
**caractérisé en ce que**
la section de stator est reliée à un autre dispositif ( URB ) de convertisseur par un autre câble ( B ) de voie, et on mesure également les valeurs ( Ib, Ub ) de courant et de tension au point ( 50 ) de liaison électrique entre l'autre câble de voie et l'autre dispositif de convertisseur et on tient compte supplémentairement de ces valeurs de mesure, lors de la détermination des paramètres.

3. Procédé suivant la revendication 1 ou 2,
**caractérisé**
**en ce que** l'on détermine comme paramètre, au moins l'un des paramètres suivants : la résistance ( R ) électrique, l'inductance ( L ), la capacité ( C ), la résistance linéique ( R' ) électrique, l'inductance ( L' ) linéique, la dérivée ( Y' ) de la conductance linéique, la capacité ( C' ) linéique et/ou la conductance ( Y ), que ce soit du câble ( A ) de voie, de l'autre câble ( B ) de voie et/ou de la section ( 10 ) de stator.

4. Procédé suivant l'une des revendications précédentes, **caractérisé en ce que** l'on mesure, respectivement de manière triphasée, les valeurs du courant et de la tension au point de liaison électrique entre le câble de voie et le dispositif de convertisseur, et les valeurs du courant et de la tension au point de liaison électrique entre le câble de voie et la section de stator, et on les exploite individuellement par ligne de phase.

5. Procédé suivant l'une des revendications précédentes, **caractérisé en ce que** l'on relève les valeurs du courant et de la tension au point de liaison électrique entre le câble de voie et la section de stator, ainsi que les valeurs du courant du côté du point neutre de la section de stator, par un dispositif ( 100 ) mobile de mesure et on les transmet à un dispositif ( 110 ) d'exploitation mobile ou fixe, par lequel on détermine les paramètres.

6. Procédé suivant l'une des revendications précédentes 1 à 4, **caractérisé en ce que** l'on relève les valeurs du courant et de la tension au point de liaison électrique entre le câble de voie et la section de stator, ainsi que les valeurs du courant du côté du point neutre de la section de stator, par un dispositif ( 100 ) de mesure fixe et on les transmet à un dispositif ( 110 ) d'exploitation mobile ou fixe, par lequel on détermine les paramètres.

7. Procédé suivant l'une des revendications précédentes, **caractérisé en ce que**

   - après la détermination des paramètres, on mesure les valeurs du courant et de la tension au point de liaison électrique entre le câble de voie et le dispositif de convertisseur, les valeurs du courant et de la tension au point de liaison électrique entre le câble de voie et la section de stator, ainsi que les valeurs du courant du côté du point neutre de la section de stator, pendant le fonctionnement du réseau à sustentation magnétique, au moins une autre fois, de préférence de façon répétée,
   - on détermine des paramètres qui s'ensuivent, respectivement à partir des valeurs de mesure, et
   - on utilise les paramètres respectifs instantanés, pour mettre à jour le jeu de paramètres.

8. Procédé suivant l'une des revendications précédentes, **caractérisé en ce que** l'on utilise les valeurs du courant et de la tension au point de liaison électrique entre le câble de voie et la section de stator, pour déterminer, pendant le fonctionnement du réseau à sustentation magnétique, la position ( x ) d'un véhicule ( F ) dans la section de stator.

9. Procédé suivant la revendication 8, **caractérisé en ce que**, pour la détermination de la position de véhicule, on tire parti supplémentairement des valeurs ( Is ) du courant du côté du point neutre de la section de stator.

10. Procédé suivant l'une des revendications précédentes, **caractérisé en ce que** l'on utilise, comme courant ( Ic ) de stator de la section ( 10 ) de stator, le courant ( Is ) mesuré au point neutre.

11. Procédé suivant l'une des revendications précédentes, **caractérisé en ce que** l'on utilise les paramètres, pour le réglage du courant de force de propulsion d'un véhicule ( F ) se trouvant dans la section de stator.

12. Système de détermination d'un jeu de paramètres, qui décrit des paramètres électriques d'une section de voie d'un réseau à sustentation magnétique, dans lequel la section de voie comprend une section ( 10 ) de stator, formant une section d'entraînement du réseau à sustentation magnétique et un câble ( A, B ) de voie, qui relie la section de stator à un dispositif ( URA, URB ) convertisseur associé,

   - dans lequel le système comporte un dispositif ( 60, 70 ) de mesure, qui est rapporté au convertisseur, qui est raccordé au point ( 40, 50 ) de liaison électrique entre le câble de voie et le dispositif de convertisseur et qui, pendant son fonctionnement, mesure les valeurs du courant et de la tension au point de liaison, et
   - dans lequel le système comporte un dispositif ( 110 ) d'exploitation, qui est en liaison avec le dispositif de mesure rapporté au convertisseur et qui détermine, avec les valeurs de mesure du dispositif de mesure rapportées au convertisseur, les paramètres du jeu de paramètres et forme ainsi le jeu de paramètres, **caractérisé en ce que**

- le système comporte supplémentairement un dispositif ( 100 ) de mesure rapporté au stator, qui est raccordé du côté de l'entrée au point ( 20 ) de liaison électrique entre le câble de voie et la section de stator, ainsi qu'au côté ( 30 ) de point neutre de la section de stator et du côté de la sortie, est en liaison directe ou indirecte avec le dispositif ( 110 ) d'exploitation, et

- dans lequel le dispositif de mesure rapporté au stator est tel qu'il mesure, pendant son fonctionnement, les valeurs du courant et de la tension au point de liaison entre le câble de voie et la section de stator, ainsi que les valeurs du courant du côté du point neutre et les transmet au dispositif d'exploitation, dans lequel

- le dispositif d'exploitation est tel qu'il tient compte supplémentairement des valeurs de mesure du dispositif de mesure rapporté au stator, lors de la détermination des paramètres et effectue les mesures, lorsque la section de stator est reliée électriquement au câble de voie.

**13.** Système suivant la revendication 12,
**caractérisé**
**en ce que** le système comporte un autre dispositif ( 70 ) de mesure rapporté au convertisseur, qui est raccordé directement ou indirectement du côté de l'entrée, au point ( 50 ) de liaison électrique entre un autre câble ( B ) de voie et un autre dispositif ( URB ) de convertisseur et du côté de la sortie, au dispositif ( 110 ) d'exploitation, et qui est tel que, pendant son fonctionnement, il mesure les valeurs du courant et de la tension au point de liaison entre l'autre câble de voie et l'autre dispositif de convertisseur et les transmet au dispositif d'exploitation.

**14.** Système suivant la revendication 12 ou 13,
**caractérisé**
**en ce que** le dispositif ( 100 ) de mesure rapporté au stator et/ou le dispositif d'exploitation sont formés par une unité mobile.

**15.** Système suivant l'une des revendications 12 ou 13, **caractérisé**
**en ce que** le dispositif ( 100 ) de mesure rapporté au stator et/ou au dispositif d'exploitation sont formés par une unité fixe.

**16.** Système suivant l'une des revendications 12 à 15, **caractérisé**
**en ce que** le dispositif d'exploitation est tel que

- il mesure au moins une autre fois, de préférence de façon répétée, après la détermination des paramètres, les valeurs du courant et de la tension au point de liaison électrique entre le câble de voie et le dispositif de convertisseur, les valeurs du courant et de la tension au point de liaison électrique entre le câble de voie et la section de stator, ainsi que les valeurs du courant du côté du point neutre de la section de stator, pendant le fonctionnement du réseau à sustentation magnétique,
- il détermine les paramètres qui s'ensuivent respectivement à partir des valeurs de mesure, et
- il utilise les paramètres instantanés respectifs, pour mettre à jour le jeu de paramètres.

**17.** Système suivant l'une des revendications 12 à 16, **caractérisé**
**en ce que** le dispositif d'exploitation est tel qu'il détermine la position d'un véhicule dans la section de stator, par les valeurs du courant et de la tension au point de liaison électrique entre le câble de voie et la section de stator, pendant le fonctionnement du réseau à sustentation magnétique.

**18.** Système suivant la revendication 17,
**caractérisé**
**en ce que** le dispositif d'exploitation est tel qu'il tire partie, pour la détermination de la position du véhicule, supplémentairement des valeurs du courant du côté du point neutre de la section de stator.

**19.** Réseau à sustentation magnétique comprenant une pluralité de sections de voie,

- dans lequel au moins l'une des sections de voie, de préférence toutes les sections de voie, sont équipées respectivement d'un système individuel décentralisé, suivant l'une des revendications précédentes de détermination d'un jeu de paramètres et
- dans lequel, pour chaque section de voie dotée d'un système décentralisé, respectivement le courant de force de propulsion de la section de voie est déterminé, en tirant parti de son jeu de paramètres déterminé de manière décentralisée.

# FIG 1

EP 2 140 278 B1

FIG 2

FIG 3

FIG 4

# FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10253865 A1

**In der Beschreibung aufgeführte Nicht-Patentliteratur**

- **Andre Veltman ; Paul van der Hulst ; Marco C.P. Jonker ; Jan P. van Gurp.** Sensorless Control of a 2.4 MW Linear Motor for launching roller-coasters. *EPE,* 2003, ISBN 90-75815-07-7